Europäisches Patentamt

European Patent Office

Office européen des brevets

(11) Publication number: **0 474 349 A2**

# EUROPEAN PATENT APPLICATION

(21) Application number: **91306558.7**

(22) Date of filing: **18.07.91**

(51) Int. Cl.5: **H01L 31/042, H01L 31/052**

(30) Priority: **16.08.90 GB 9017982**

(43) Date of publication of application:
**11.03.92 Bulletin 92/11**

(84) Designated Contracting States:
**DE FR IT**

(71) Applicant: **EEV LIMITED**
**106 Waterhouse Lane**
**Chelmsford, Essex, CM1 2OU(GB)**

(72) Inventor: **Cross, Trevor Arthur,Dr.**
**45 Primrose Hill**
**Chelmsford, Essex CM1 2RH(GB)**
Inventor: **Hardingham, Christopher Mark**
**7 Swallow Path**
**Chelmsford, Essex CM2 8XT(GB)**

(74) Representative: **Cockayne, Gillian et al**
**The General Electric Company plc Patent**
**Department GEC Marconi Research Centre**
**West Hanningfield Road**
**Great Baddow, Chelmsford Essex CM2**
**8HN(GB)**

(54) **A solar cell arrangement.**

(57) A solar cell arrangement comprises two transparent cover plates 33 and 34 having recesses within which are located interconnection means which interconnect solar cells. By locating the interconnection means within the recesses the solar cells can be intimately bonded without an adhesive to the cover plates 33 and 34 making the arrangement lighter.

Fig.8

This invention relates to solar cell arrangements.

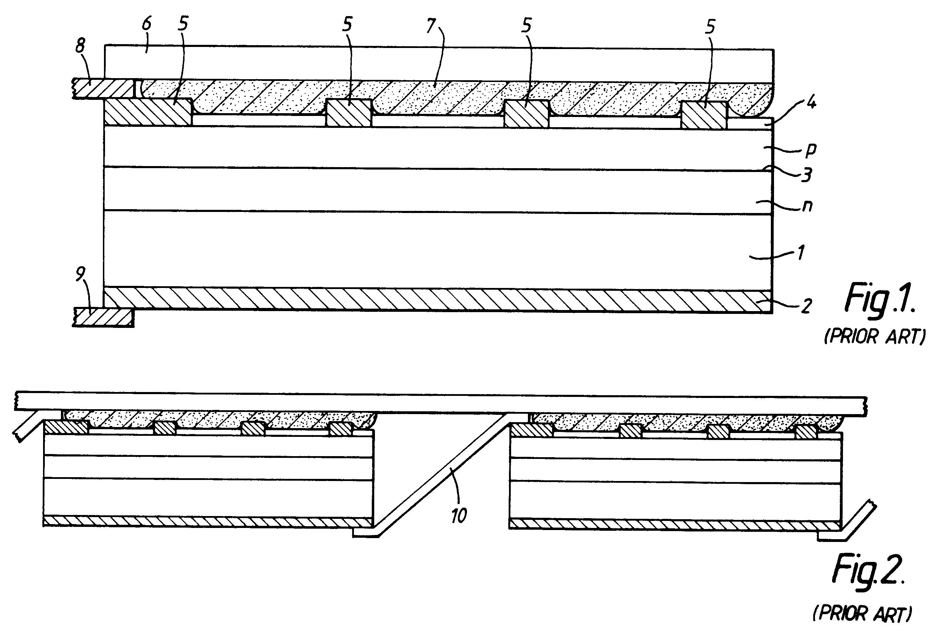

Solar cells are semi-conductor devices used to convert light into electricity. They usually comprise n and p type semi-conductor layers forming a junction. A section through a typical solar cell is shown in Figure 1. The solar cell comprises a substrate 1 with a back contact 2 of metal deposited by a vacuum deposition technique. The p and n layers are laid down on the substrate, which supports them, to form a junction 3. A conductive layer 4 is formed on the upper surface of the p layer and selectively etched and the exposed p layer metallised to produce a contact grid 5. A coverglass 6 protects the cell from dust, abrasion and particle irradiation, and is glued into position by adhesive 7. Connections 8 and 9 are made to the grid 5 and rear metallisation 2.

When light is directed onto the front of the solar cell in the direction shown by the arrow hole-electron pairs are formed which result in a migration of charge carriers, creating a difference in potential between the n and p layers which can be used to drive an electric current through an external load connected across the connections 8 and 9.

Solar cells are familiar objects to many people, being used in every day objects such as solar powered calculators and watches. It was, however, the requirements for powering spacecraft that led to their development and it is this exacting area of technology which is giving rise to further improvements in solar cells.

The maximum area of a high efficiency single crystal cell is generally of the order of about $60cm^2$, it being difficult to fabricate cells having a larger surface area. The power each cell can produce is accordingly modest being about a watt without optical concentration. Therefore to meet the power requirements of a satellite, many cells must be used. A typical solar cell arrangement as shown in Figure 2 includes a plurality of solar cells two of which are shown glued to a cover plate and electrically interconnected by an interconnect 10. Similar interconnects form the electrical connection means throughout the arrangement and it is usual to connect the cells in series. A number of arrangements are mounted together to form solar panels having a large surface area and hence a large collective power output.

As a satellite orbits the Earth, it passes from full sun into shadow and experiences a thermal cycle as it does so. For a typical orbit, the cycle range is from $-100°C$ to $+80°C$. The change in temperature accordingly causes expansion or contraction of the interconnects, the effect of which, over a number of cycles, is to fatigue the links. The possible resultant breakage of even one link can be serious, for, in a series arrangement, a large section of the solar panel may fail as a result.

Given the cost per kilogram of launching a satellite into orbit, it is important to reduce the weight of every component of the satellite as much as is possible. Much effort has been expended in attempts to reduce the weight of solar cells, for although each cell may appear to have an insignificant weight, the large numbers required to power a satellite make every small reduction in the weight of each cell worthwhile. For instance, even the density of the semiconductor material used in the solar cell is important.

One way in which weight can be saved is by making the solar cells as thin as possible by etching away the substrate and relying on the coverglass for support by gluing the cell to the coverglass but as the solar cell is made thinner it becomes increasingly fragile. Glues tend to age rapidly in space due to extremes in the temperature cycle and, of course, exposure to intense solar radiation unfiltered by an atmosphere. The effect of ageing can be to degrade the glue making it increasingly opaque and so reducing the radiation reaching the cell, which causes a drop in the cells output power over a period of time.

According to a first aspect of the invention there is provided a solar cell arrangement comprising: a support having at least one recess therein; at least one solar cell directly bonded to the support and at least partially covering the recess and electrical connection means located within the recess and connected to at least one of the layers of the covering portion of the solar cell.

By providing recesses in the support, the electrical connections may be made to the solar cell in such a manner that the connections do not add to the thickness of the arrangement and are flush with the cover plate surface. A direct bond, that is, a bond not requiring an adhesive can then be made by, for example, heating the support and pressing the solar cell into intimate contact with it. Because the connections are flush with the surface, this avoids areas of high localised stress which would otherwise occur and cause fractures in the semiconductor material.

Preferably the electrical connection means is at least partly a metallisation layer. Coveniently, the support is a coverglass. Whilst the coverglass is usually made of glass it may be possible to make it from other materials, for example, plastics and coverglass should be interpreted accordingly.

Advantageously, a second coverglass is bonded to the back of an arrangement in accordance with the invention as previously described.

Preferably, the arrangement has a plurality of interconnected solar cells and a plurality of recesses in the support, the cells being electrically interconnected by the electrical connection means at least partially within the recess. A plurality of solar cells so linked would provide a combined power output.

Preferably a second support is provided bonded to the rear of the solar cells bonded to the first support, the cells being electrically interconnected by electrical connection means located in the recesses of the supports.

The electrical connection means may be arranged to connect layers of adjacent cells such that the front layer of one cell is connected to the rear layer of the adjacent cell. In some arrangements, the means might be arranged to connect the front layer of one cell to the front layer of its adjacent cell by means in the recesses of one of the supports and the rear layers being similarly connected by means in the recesses of the second plate.

Advantageously, a reflector is provided to reflect radiation to at least one surface of the solar cell or cells. This will allow the power output to be potentially doubled because both surfaces may be utilised. Since both surfaces may be utilised, each cell will receive the same amount of radiation so avoiding current inequalities due to the differing spectral responses of p and n surfaces which reduce an array's efficiency when only one set of surfaces of the cells in an array are illuminated.

Conveniently, the reflector reflects radiation to both surfaces of the solar cell or cells. This allows radiation to be gathered over a large area and then "concentrated" over the solar cell surface area making the greatest use of the cell. Further concentration can be conveniently achieved by a parabolic reflector which focuses radiation onto both sides.

Although only one of the supports need be transparent, where radiation is advantageously reflected to the rear of the arrangement by a reflector both supports may be transparent to allow the radiation to pass through the rear support. The reflector may be a manmade reflector or in some circumstances a celestial body such as the Earth.

According to a second aspect of the invention, there is provided a method of making a solar cell arrangement comprising recessing at least one portion of a support; providing an electrically conductive layer within the recess; and directly bonding a solar cell to the support.

By recessing the support, which may be a protective glass coverglass, and making the electrical connection at this region, it is possible to make an intimate bond between the support and the solar cell without the requirement for adhesive, as the face of the solar cell can be flush with the face of the support with any projections on the cell located within the recess or recesses. The recess may be made by selectively etching the support or by grinding, for example. Preferably, the electrically conductive layer is a metal deposited by a vacuum deposition technique. Whilst this is preferable, it may also be possible to provide the layer by painting, printing the recess with an electrically conductive ink which dries to form a layer, by insertion in the recess of a metal link or by some other way.

Advantageously, thinning the solar cell is carried out after bonding.

Thinning after bonding is advantageous because the solar cell can be made thick enough to be easily handled and bonded to the support without damage and then subsequently thinned. The thinning process reduces the weight of the arrangement.

Conveniently, the thinning is carried out by chemical means such as etching the solar cell. It may also be possible to carry out the thinning process by other means such as mechanical means, for instance grinding the cell.

Preferably, a plurality of recesses are made in the support and a plurality of solar cells are positioned such that the recesses are adjacent to electrical connection means on the solar cells prior to bonding. The electrical connection means may be a metallised grid made on the solar cell surface for making electrical contact with for instance, the p layer which may project from the surface.

Preferably, more than one solar cell is bonded to the support and the cells electrically interconnected by the electrically conducting layer.

Although it is possible that the electrical connections may be achieved by purely physical contact, preferably, the interconnections are fused together. This might be achieved by transmitting energy from a laser, for instance, through the support to selectively melt and fuse the connections together. Advantageously, a rearwards layer of the or each solar cell is provided with a pick-up grid after thinning.

By providing a pick-up grid on a rearwards layer, the solar cell can be illuminated through the support and front face and also through the rearmost surface potentially doubling its power output.

Specific embodiments of the invention are now described by way of example only, with reference to the accompanying drawings in which:

Figures 3 to 9 schematically show respective solar cell arrangements in accordance with the invention; and

Figures 10 to 11 show the use of reflectors to reflect radiation onto solar cell arrangements in accordance with the invention.

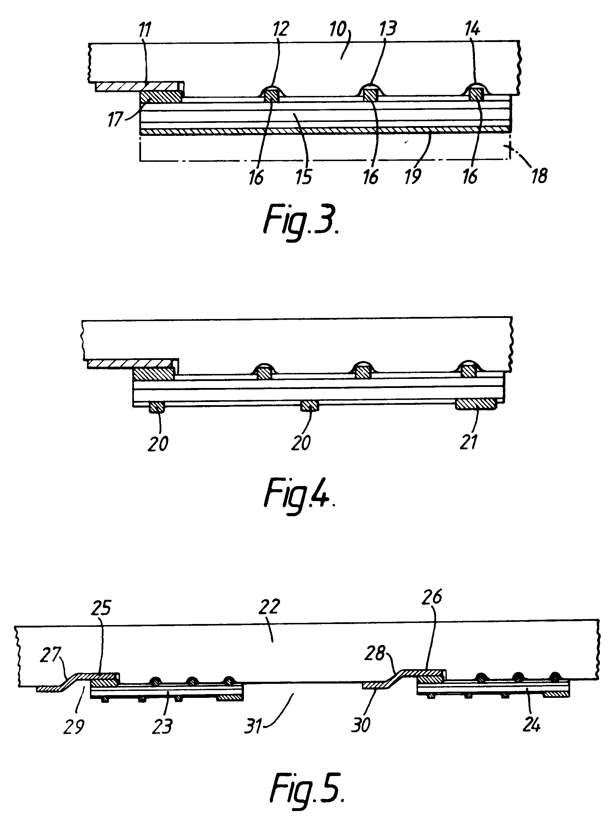

With reference to Figure 3, a single solar cell is produced by etching a glass coverglass 10 to produce recesses 11, 12, 13 and 14. The glass coverglass 10 has a thickness in the range of 50 to 500 microns. After etching, the coverglass is metallised within the recess 11 by a vacuum deposition technique well known to those versed in the art of solar cell manufacture. A solar cell 15 is bonded to the coverglass 10 by heating the coverglass, applying an electrostatic potential between the coverglass and solar cell, and pressing the solar cell 15 into contact. Before pressing into contact, the solar cell's metallisation layers, comprising a grid 16 and a contact pad 17, having a thickness of 5 microns, are aligned with the recesses 12 to 14 and 11 respectively.

With the solar cell 15 supported by the coverglass 10, the substrate 18 (shown dotted) is etched away to lighten the solar cell 15 before back metallisation 19 of thickness 5 microns is applied which forms the rear contact of the solar cell 15. Front connection to the solar cell 15 is made by fusing the contact pad 17 to the metallisation layer within the recess 12. The removal of the substrate allows, in another embodiment, a rear grid to be provided as shown in Figure 4 where after removal of the substrate a back grid 20 and a back contact 21 is produced by metallisation and selective etching. The grid 20 allows light from the rear of the cell to pass towards the junction, thereby increasing the cell's output. It is a bifacial solar cell because it has two light sensitive directions as described above.

Metallisation layers within recesses in the coverglass may be used to link together a number of cells. One way in which this may be achieved is by producing a directly bonded, bifacial sub-module as shown in Figure 5, in which a coverglass 22 is etched to provide recesses to accommodate grids of solar cells 23 and 24. Recesses 25 and 26 have inclined faces 27 and 28 respectively and are metallised to form metallisation layers 29 and 30. The cells 23 and 24 are bonded, etched, metallised and the layers of metallisation fused as before. In the figure, the p layers of the solar cells are uppermost, that is, they are closest to the coverglass 22.

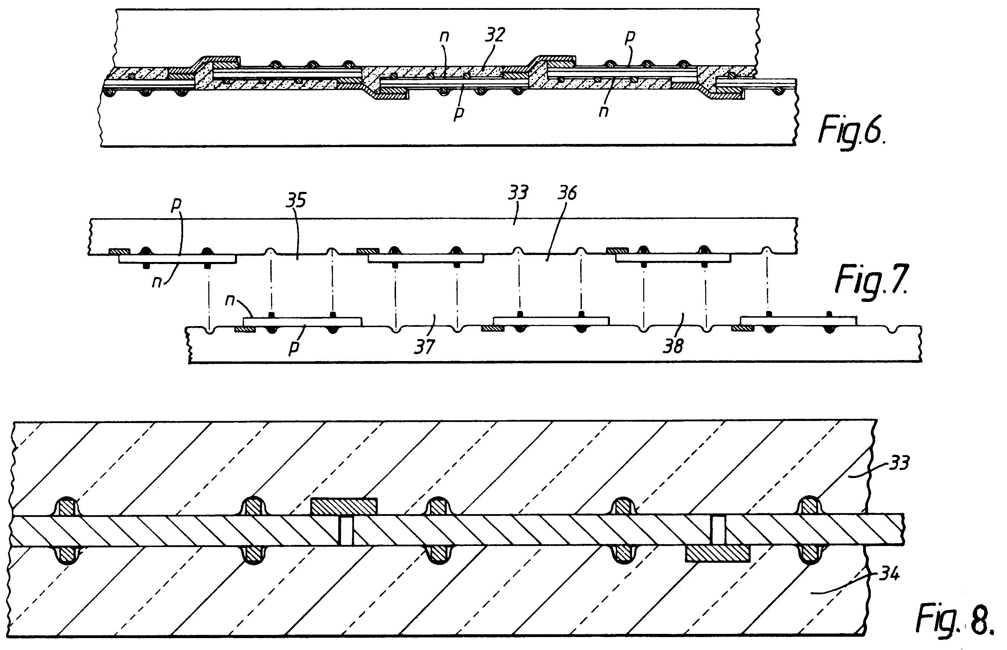

Another nominally identical sub-module is made as before and then aligned with the other, such that each solar cell of each sub-module is adjacent with a region, such as 31, between the cells of the other sub-module. The modules are then glued together with adhesive 32 as shown in Figure 6, a suitable adhesive being Dow Corning 93-500 controlled volatility encapsulant. The coverglass metallisation layers are fused as before to interconnect the cells and connect p layers to n layers to form a series arrangement.

In another embodiment of the invention, as shown in Figure 7, glass coverglasses 33 and 34 with solar cells bonded as before are etched (prior to the bonding of the solar cells) to provide recesses in the regions between the solar cells, 35, 36, 37 and 38. These recesses are provided to accommodate grid electrodes of the solar cells of the other sub-modules. After construction of the sub-modules in a similar manner to the embodiments hereinbefore described, they are aligned, re-heated, and pressed together as shown in Figure 8. In this arrangement there is no adhesive required to join the sub-modules since all the bonds are direct bonds.

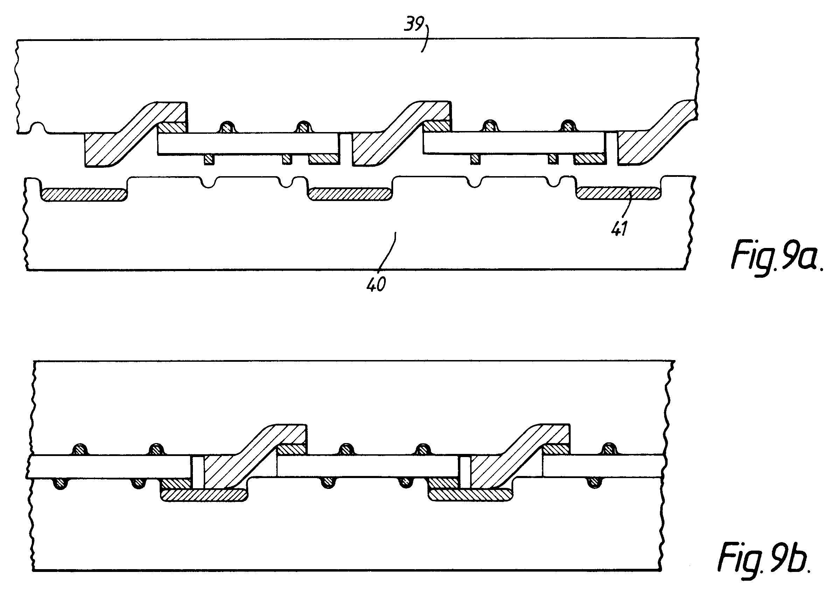

Whilst in the previous embodiments, a pair of submodules of solar cells bonded to a coverglass have been made, it will be appreciated that all the cells may be bonded to one coverglass to form one subassembly and the second coverglass may then be bonded to the subassembly. This is shown in Figure 9a in which solar cells are directly bonded to a coverglass 39 to form the first subassembly. The second subassembly is formed by etching recesses in a coverglass 40 and metallising them with metallisation layers one of which is labelled 41. The two subassemblies are then bonded and the interconnections made as before. The completed arrangement is shown in Figure 9b. This arrangement conveniently achieves connection between the upper and lower layers of adjacent cells which avoids the requirement of having the p and n layers coplanar for a series arrangement.

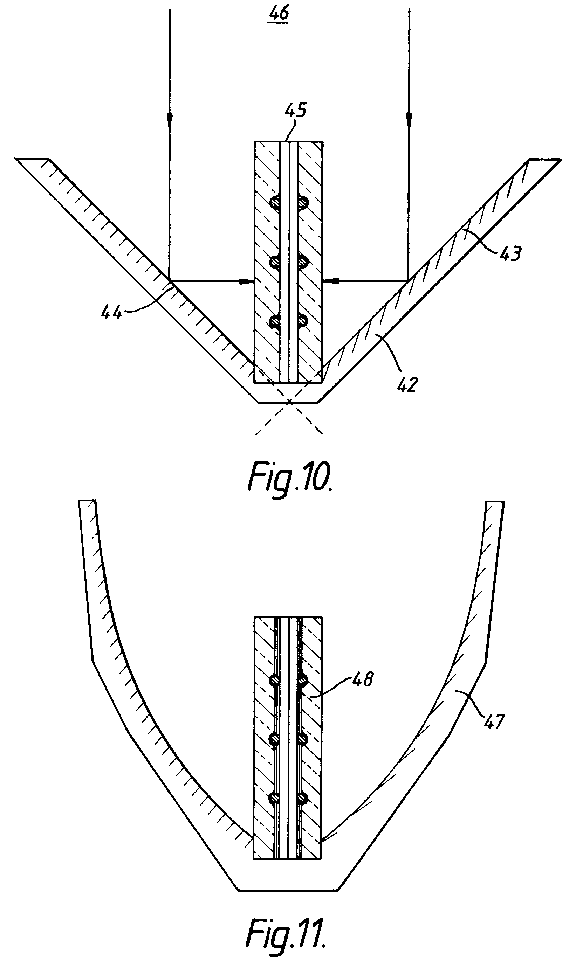

Radiation can be reflected onto both faces of the bifacial arrangements described, as shown in Figure 10, where a reflector 42 is formed such that its reflecting surfaces 43 and 44 are orthogonal. A bifacial solar cell arrangement 45 which receives radiation reflected from a direction 46 is fixed equidistant between the reflective surfaces 43 and 44. In an alternative embodiment shown in Figure 11, a parabolic reflector 47 is used to collect and concentrate radiation onto a bifacial solar cell arrangement 48.

## Claims

1. A solar cell arrangement comprising: a support (10) having at least one recess (11-14) therein; at least one solar cell (15) directly bonded to the support and at least partially covering the recess, and electrical connection means (16, 17) located within the recess connected to at least one of the layers of the covering portion of the solar cell.

2. A solar cell arrangement as claimed in claim 1 wherein the electrical connection means (17) is at least partly a metallisation layer.

3. A solar cell arrangement as claimed in claims 1 or 2 wherein the support is a coverglass (10).

4. A solar cell arrangement as claimed in claim 1, 2 or 3 and including a coverglass (Figure 6, 38, 40) bonded to the back of the solar cell.

5. A solar cell arrangement as claimed in claim 1, 2, 3 or 4 and including a plurality of interconnected solar cells (23, 24) and a plurality of recesses (25, 26) in the support (22), each solar cell being associated with at least one respective recess and electrically interconnected by the electrical connection means (29, 30) located within the recess.

6. A solar cell arrangement as claimed in claim 5 when not dependent on claim 4 wherein a second support is provided bonded to the rear of the solar cells bonded to the first support, the cells being electrically interconnected by electrical connection means located in the recesses of the supports (Figure 6).

7. A solar cell arrangement as claimed in claim 6 wherein both supports are substantially transparent (Figure 6).

8. A solar cell arrangement as claimed in claim 6 or 7 wherein the electrical connection means connect the n type layer of one solar cell to the p type layer of an adjacent cell (Figure 6).

9. A solar cell arrangement as claimed in claim 8 wherein the p type and n type layers of one cell are inverted with respect to p type and n type layers of an adjacent cell (Figure 6).

10. A solar cell arrangement as claimed in any preceding claim wherein the recess (25, 26) has an inclined face (27, 28) with respect to the main surface of the cell and the supports.

11. A solar cell arrangement as claimed in any preceding claim including reflector means (43, 44) to reflect radiation to at least one surface of the solar cell or cells (45).

12. A solar cell arrangement as claimed in claim 11 wherein the reflector means (43, 44) reflects radiation to major faces of the solar cell or cells (45).

13. A solar cell arrangement as claimed in claim 12 wherein the reflector means comprises two reflective surfaces (44, 45) arranged at 45° to the major faces of the solar cell or cells.

14. A solar cell arrangement as claimed in claim 12 wherein the reflector means is a parabolic reflector (47).

15. A solar panel comprising an array of arrangements as claimed in any preceding claim.

16. A method of making a solar cell arrangement comprising: recessing (11-14) at least one portion of a support (10); providing an electrically conductive layer within the recess; and directly bonding a solar cell (15) to the support.

17. A method as claimed in claim 16 wherein more than one portion of the support is recessed.

18. A method as claimed in claims 16 or 17 including depositing the electrically conductive layer within the recess by a vacuum deposition technique.

19. A method as claimed in claims 16, 17 or 18 including thinning the solar cell after bonding to the support.

20. A method as claimed in claim 19 wherein the solar cell is thinned by etching.

21. A method as claimed in any one of claims 16 to 20 comprising recessing a plurality of recesses (25, 26) in the support (22); and positioning a plurality of solar cells (23, 24) such that the recesses are adjacent to electrical connection means on the solar cells prior to bonding.

22. A method as claimed in any one of claims 16 to 21 including directly bonding solar cells to the support (22) such that each cell (23, 24) at least partially overlaps a recess (25, 26) and electrically connecting each cell to adjacent cells by the electrically conductive layer.

23. A method as claimed in any one of claims 16 to 22 including providing a pick up grid on (20) a rear surface of the/or each solar cell after thinning.

24. A method of making a solar cell arrangement comprising the steps of:
   1. recessing at least one portion of a support,
   2. providing an electrically conductive layer within the recess,
   3. heating the support,
   4. directly bonding at least one solar cell to the support and
   5. thinning the solar cell by etching;
repeating steps 1 to 5 to make a second solar cell arrangement; aligning the arrangements such that a solar cell of the first arrangement is opposite a vacant position in the other arrangement; pressing together the first and second solar cell arrangements and reheating the supports such that each cell is directly bonded to both supports (Figure 5, Figure 6).

25. A method as claimed in any one of claims 16 to 24 including bonding the electrically conductive layer to electrical connection means on the solar cells.

Fig.1.
(PRIOR ART)

Fig.2.
(PRIOR ART)

EP 0 474 349 A2

Fig.3.

Fig.4.

Fig.5.

Fig.6.

Fig.7.

Fig.8.

EP 0 474 349 A2

Fig.9a.

Fig.9b.

46

45

43

44

42

Fig.10.

48

47

Fig.11.